Europäisches Patentamt

European Patent Office

Office européen des brevets

(11) Publication number: **0 019 883**
**B1**

# EUROPEAN PATENT SPECIFICATION

(45) Date of publication of patent specification: **27.08.86**

(51) Int. Cl.⁴: **H 01 L 23/48, H 01 L 23/52**

(21) Application number: **80102895.2**

(22) Date of filing: **23.05.80**

(54) Semiconductor device comprising a bonding pad.

(30) Priority: **24.05.79 JP 63219/79**

(43) Date of publication of application:
**10.12.80 Bulletin 80/25**

(45) Publication of the grant of the patent:
**27.08.86 Bulletin 86/35**

(84) Designated Contracting States:
**DE FR GB**

(56) References cited:
**FR-A-2 027 664**
**FR-A-2 219 527**
**FR-A-2 375 718**

**IBM TECHNICAL DISCLOSURE BULLETIN, vol.
21, no. 3, August 1978, pages 1052-1053, New
York (USA); J.GNIEWEK et al.: "Dual insulators
for planar multilevel interconnections"**

(73) Proprietor: **Kabushiki Kaisha Toshiba
72, Horikawa-cho Saiwai-ku
Kawasaki-shi Kanagawa-ken 210 (JP)**

(72) Inventor: **Komatsu, Shigeru
3-3-206, Iijima-danchi 527 Iijima-cho
Totsuka-ku Yokohama-shi (JP)**
Inventor: **Fujita, Katsuji
1607-6, Nakata-cho
Totsuka-ku Yokohama-shi (JP)**

(74) Representative: **Henkel, Feiler, Hänzel & Partner
Möhlstrasse 37
D-8000 München 80 (DE)**

## Description

This invention relates to a semiconductor device, as defined in the precharacterizing part of the claim 1.

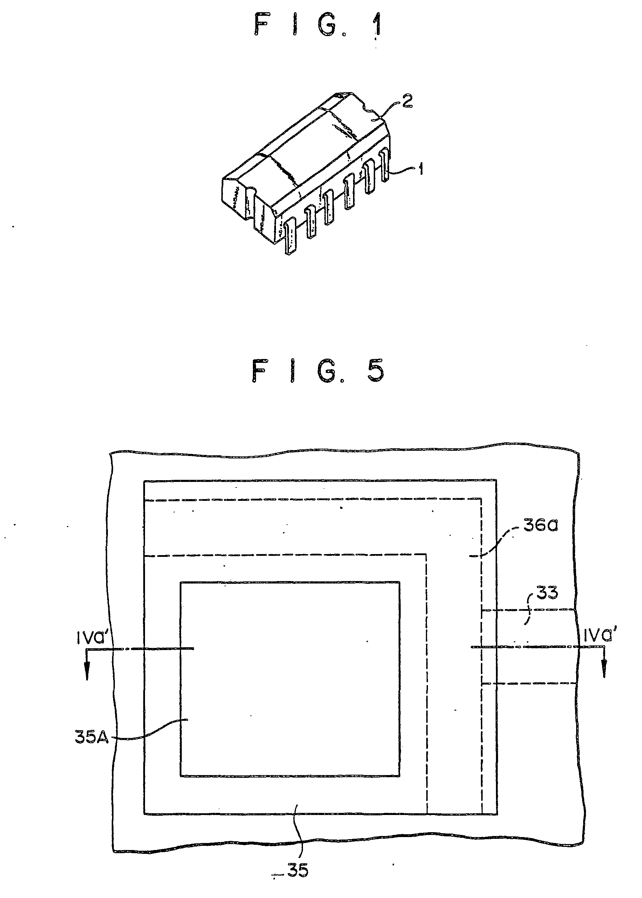

A semiconductor device manufactured by arranging a large number of semiconductor elements in the form of an integrated or large scale integrated circuit is widely marketed. In this case, the chip of the body of a semiconductor device on which a large number of semiconductor elements are integrated is fitted to, for example, the chip-carrying plane of a lead frame. The chip is bonded with external leads, for example, by a gold wire (wire bonding). The lead frame is cut off, after the semiconductor device is sealed in resin. A large number of external leads 1 (Fig. 1) are made to protrude from a molded resin block 2. Thus a customary semiconductor device is marketed in the form of a package as illustrated in Fig. 1. The reliability of a semiconductor device thus manufactured is governed not only by the quality of the chip but also by the process of bonding the chip with the external leads.

The customary wire bonding process is to thermally deposit a very fine gold wire having a diameter of about 25 μm under pressure across the chip and external leads. With the integrated circuit, a mechanically strong nail head bonding process is applied. Further utilized is another form of bonding process known as the U.S. bonding process which is to deposit an aluminium wire while applying ultrasonic vibrations.

In recent years, an aluminium alloy containing, for example, several percents of silicon or copper has come to be accepted in place of the conventional pure aluminium wiring layer as a metal wiring electrode for connecting semiconductor elements with each other integrated on a semiconductor chip.

With a vertical type transistor, an emitter region is diffused with a small depth. Where a metal electrode set on the emitter region is made of pure aluminium, then silicon lying below said electrode is absorbed into the aluminium during heat treatment, sometimes giving rise to short-circuiting between the emitter and base regions of the transistor. Application of an aluminium-silicon alloy is useful to suppress the occurrence of the above-mentioned event. This aluminium-silicon alloy is also effective not only to ensure improvement on the machining precision of a metal wiring layer but also to prevent the formation of protuberances on a metal wiring layer generally referred to as "hillocks".

On the other hand, an aluminium-copper alloy is effective not only to prevent the breakage of a wiring layer resulting from electromigration (heat buildup caused by the flow of electrons) which often raises problems in the minute machining of a wiring layer and the application of a large current element but also to improve the moisture proofness of a wiring layer.

However, it has been found that addition of an impurity displaying the above-mentioned excellent effect to an aluminium wiring layer is not always preferred for improvement on the reliability of the aforesaid wiring layer bonding process. In other words, it has been disclosed that where a wire bonding pad is formed of an aluminium alloy, the adhesivity of the bonded portion of a semiconductor device noticeably decreases, unlike the case where the bonding pad is formed of pure aluminium, thereby reducing the reliability of wire bonding.

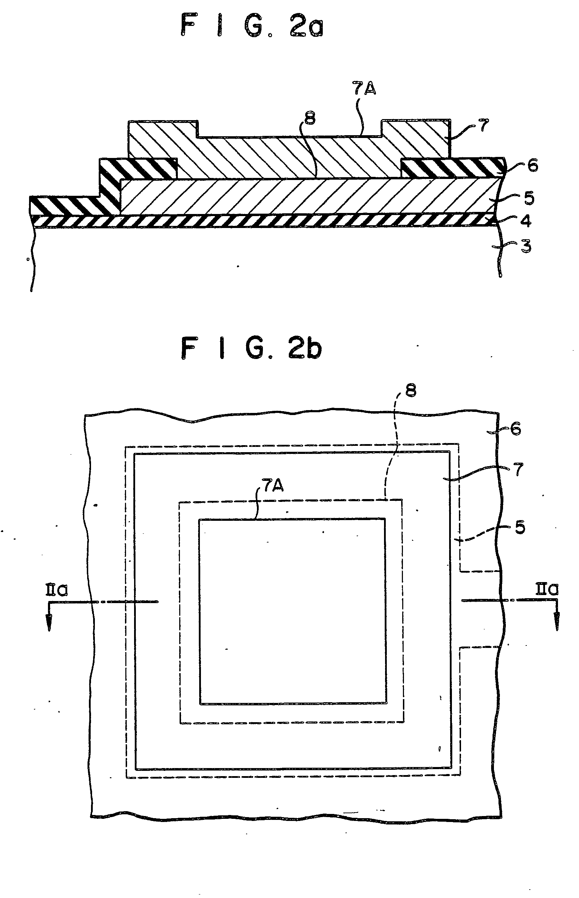

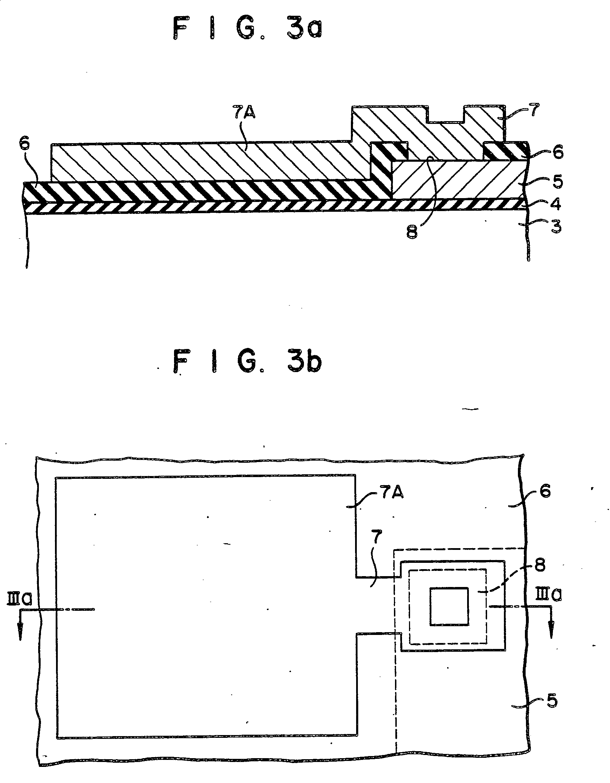

For elimination of the above-mentioned drawbacks accompanying an aluminium alloy, various attempts have been made to construct a bonding pad by depositing a pure aluminium layer on an aluminium alloy layer. However, none of these attempts have proved satisfactory. Figs. 2a, 2b, 3a and 3b illustrate the structure of the previously attempted bonding pad sections of a semiconductor device.

With the wire bonding pad shown in Figs. 2A and 2B, an aluminium alloy wiring layer 5 is deposited on a semiconductor substrate 3 whose surface is covered with a thermally oxidized layer 4 in order to connect integrated semiconductor elements (not shown) with each other. An electric insulation protective layer 6 is mounted on said aluminium alloy wiring layer 5 in the prescribed positions. A pure aluminium electrode 7 is deposited on the exposed portion 8 (indicated in broken line in Fig. 2b) of said aluminium alloy wiring layer 5 and those portions of the electric insulation protective layer 6 which surround the exposed portion 8 of the aluminium alloy wiring layer 5. The above-mentioned prior art process is used to provide a bonding pad 7A.

With the aforesaid construction of a bonding pad, it is necessary to undertake heat treatment called sintering in order to effect an ohmic contact between the aluminium alloy wiring layer 5 and pure aluminium electrode 7. During the sintering process which is carried out at a temperature of 400 to 530°C, an additive of silicon or copper contained in the aluminium alloy wiring layer 5 quickly migrates into the pure aluminium electrode 7, and is concentrated with an abnormally high density on the surface of the pure aluminium electrode 7. This event leads, as previously described, to a decline in bonding adhesivity, a reduction in the yield of a semiconductor device due to unsatisfactory bonding, and eventually a decrease in the reliable performance of the semiconductor device.

The prior art bonding pad manufacturing process (Figs. 3a and 3b) comprises the steps of depositing an aluminium alloy wiring layer 5 on a semiconductor substrate 3 whose surface is covered with a thermally oxidized layer 4 to connect integrated semiconductor elements (not shown) with each other; mounting an electric insulation protective layer 6 on the aluminium alloy wiring layer 5 in the prescribed positions; forming a pure aluminium electrode 7 not only on the exposed portion 8 of the aluminium alloy wiring layer 5 (indicated in a broken line in Fig. 3b) but also on that part of the electric insulation protection layer 6 which is apart from said exposed portion 8 of the aluminium alloy wiring layer 5. That portion 7A of the pure aluminium electrode 7 which is deposited on that part of the electric insulation protective layer 6 which lies apart from said exposed portion 8 of the aluminium alloy wiring layer 5 is used as a bonding pad.

With the prior art bonding pad manufacturing process (Figs. 3a and 3b), sintering causes an additive of silicon or copper contained in the aluminium alloy wiring layer 5 to migrate into the pure aluminium electrode 7 in the junction between said aluminium alloy wiring layer 5 and pure aluminium electrode 7. However, the bonding pad region 7A which contacts the electric insulation protective layer 6 is saved from the intrusion of the above-mentioned additive of silicon or copper. However, the electric insulation protective layer 6 which is usually deposited at a lower temperature than 400°C in a soft state acts as a buffering means and objectionably absorbs the bonding energy to render the bonding process unreliable.

In document FR—A—2027664 there is described a semiconductor device comprising a semiconductor substrate, a first insulation layer deposited on the main surface of the semiconductor substrate, a first conductor wiring layer disposed on the first insulation layer, a second insulation layer on the first conductor wiring layer and the first insulation layer and a second wiring layer contacted with the first conductor wiring layer at an area laterally removed from a bonding pad area of the second wiring layer which is exposed through an opening in the second insulating layer whereby the bonding pad area overlies a portion of the first insulation layer which is not directly under the contact area between the first and second wiring layers. Instead of pure metals one could also employ alloys for the conductive wiring layers. In the contact area, a metal layer is formed on the second wiring layer, and this metal layer is in contact with the connecting layer. The presence of this metal layer tends to impair the bonding strength because the metal layer acts as a buffering layer in the wire bonding process.

Furthermore, document FR—A—2375718 discloses a semiconductor device in which multilayer wiring is used to provide contact between lower and upper conductive layers through an opening in an intervening insulating layer.

It is an object of the present invention to provide a semiconductor device in which the semiconductor elements and external leads are bonded together with greater adhesivity than has been possible in the past.

To this end, the present invention provides a semiconductor device having a bonding pad, comprising: a semiconductor substrate on which at least one semiconductor element is formed, a first insulation layer deposited at least partly on the main surface of the semiconductor substrate, a first alloy wiring layer contacting the semiconductor element disposed on the first insulation layer, a second insulation layer mounted on the first alloy wiring layer and first insulation layer, and a second wiring layer contacted with the first alloy wiring layer, part of the second wiring layer constituting a bonding pad area; said semiconductor device being characterised in that the bonding pad area is laterally shifted from an area where the second wiring layer contacts the first alloy wiring layer through an opening in the second insulation layer, the first insulation layer has a relatively high density as compared to the density of the second insulation layer, and the bonding pad area is provided only on the first insulation layer.

This invention can be more fully understood from the following detailed description when taken in conjunction with the accompanying drawings, in which:

Fig. 1 is an oblique view of a prior art resin package semiconductor device;

Fig. 1a is a sectional view on line IIa—IIa of Fig. 2b indicating a bonding pad section for the external leads of a prior art semiconductor device;

Fig. 2b is a plan view of the upper portion of Fig. 2a;

Fig. 3a is a sectional view on line IIIa—IIIa of Fig. 3b illustrating another form of a bonding pad section for the external leads of the prior art semiconductor device;

Fig. 3b is a plan view of the upper portion of Fig. 3a;

Fig. 4a is a sectional view on line IVa—IVa of Fig. 4b showing a bonding pad section for the external leads of a semiconductor device according to one embodiment of this invention;

Fig. 4b is a plan view of the upper portion of Fig. 4a;

Fig. 5 is a plan view of a bonding pad section for the external leads of a semiconductor device according to another embodiment of this invention;

Fig. 6a is a sectional view on line VIa—VIa of Fig. 6b showing a bonding pad section for the external leads of a semiconductor device according to still another embodiment of the invention; and

Fig. 6b is a plan view of the upper portion of Fig. 6a.

There will now be described by reference to the appended drawings a semiconductor device embodying this invention.

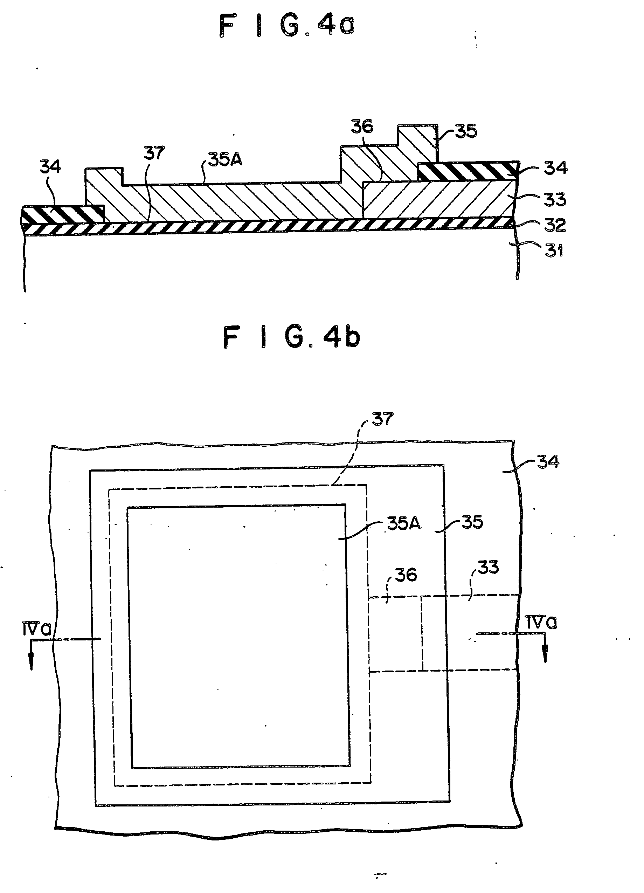

Referring to Figs. 4a and 4b, reference numeral 31 denotes a semiconductor substrate on which semiconductor elements (not shown) are integrated. For example, a first electric insulation layer formed of a thermally oxidized layer 32 is deposited on the main surface of said semiconductor substrate 31. Mounted on part of the surface of the first electric insulation layer 32 is a first alloy wiring layer 33 such as an aluminium alloy wiring layer containing at least one of the group consisting of silicon, copper, palladium, molybdenum and titanium or a polysilicon alloy wiring layer containing any other metal than silicon to connect together the semiconductor elements (not shown) integrated on the semiconductor substrate 31. Deposited, for example, by sputtering at a low temperature in the proper portions of the surfaces of the first alloy wiring layer 33 and first electric insulation layer 32 is a second electric insulation layer 34 formed of an inorganic material such as a metal oxide or an organic material such as polyimide or fluorine resin in such a manner that an opening is formed in at least one portion of said second electric insulation layer 34 to alloy for the formation of an electrode for a bonding pad. Formed in said opening is a pure aluminium electrode 35, one part of which contacts the first electric insulation layer 32, and the other part of which contacts the first alloy wiring layer 33. With the above-mentioned construction, a bonding pad is constituted by that portion 35A of the pure aluminium electrode 35 which contacts the first electric insulation layer 32. Where sintering is applied to effect ohmic connection between the pure aluminium electrode 35 and first alloy wiring layer 33, an additive, for example, silicon or copper contained in the first alloy wiring layer 33 migrates into the pure aluminium electrode 35 at a junction 36 between said pure aluminium wiring layer 35 and first alloy wiring layer 33. In this case, however, a region 37 (indicated in broken lines in Fig. 4b) lying under the bonding pad 35A contacts the first insulation layer 32, thereby preventing an additive such as silicon or copper frame being carried from the first alloy wiring layer 33 into said bonding pad 35A. The first electric insulation layer 32 may be formed of a thermally oxidized layer produced during the integration of semiconductor elements (not shown) on the semiconductor substrate 31, or a layer of, for example, SiN or SiO$_2$ which is deposited by the chemical vapor deposition process and later heat treated at a high temperature. In either case, the first electric insulation layer 32 is found to have a dense struction. During the wire bonding operation, therefore, the first electric insulation layer 32 does not substantially take a buffer action, enabling wire bonding to be carried out with a sufficiently high degree of adhesivity.

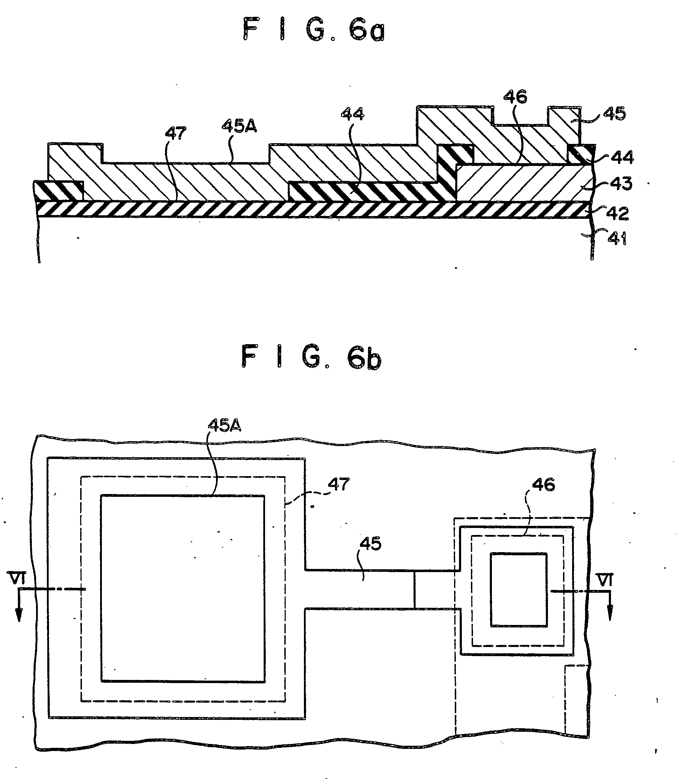

With a semiconductor device according to a second embodiment of this invention (Fig. 5), a junction between the first alloy wiring layer 33 and pure aluminium electrode 35 is enlarged into an inverted "L" shape as seen from a broken line section 36a. The second embodiment of Fig. 5 is little different from the first embodiment of Figs. 4a and 4b in other respects. The sectional view on line IVa'—IVa' of Fig. 5 is substantially the same as that of Fig. 4a. Therefore, the description of Figs. 4a and 4b also applies to the second embodiment of Fig. 5. In other words, an additive such as silicon or copper contained in the first alloy wiring layer 33 does not migrate into the bonding pad 35A, thereby enabling wire bonding to be carried out with a sufficiently high degree of adhesivity.

There will now be described by reference to Figs. 6a and 6b a semiconductor device according to a third embodiment of this invention. A first alloy wiring layer 43 is mounted on a semiconductor substrate 41 whose main surface is covered with a thermally oxidized layer. A second electric insulation layer 44 is deposited on said first alloy wiring layer 43 in such a manner that the portion 46 of the first alloy wiring layer 43 and the portion 47 of the first electric insulation layer 42 are exposed. A second pure aluminium wiring layer 45 is stretched between and over the exposed portions 46, 47. Further, the second pure aluminium wiring layer 45 may be provided by vacuum depositing a layer of pure aluminium all over the underlying surface after the formation of the above-mentioned exposed portions or openings 46, 47 and later patterning said aluminium layer by photoetching.

Where the second electric insulation layer 44 is formed of SiO$_2$ by the so-called chemical vapor deposition (CVD) process, then it is necessary to provide an opening by selectively etching off only the second electric insulation layer 44. An SiO$_2$ layer formed by the CVD process has a lower density than the thermally oxidized layer of SiO$_2$. Therefore, the CVD-processed SiO$_2$ layer alone can be selectively removed by utilizing the high etching speed at which said CVD-processed SiO$_2$ layer is etched by a hydrofluoric acid.

Where sintering is carried out to effect an ohmic contact between the first alloy wiring layer 43 and second pure aluminium wiring layer 45, then the additive of the first alloy wiring layer 43 tends to migrate into the second pure aluminium wiring layer 43 at the junction 46 between both wiring layers 43, 45. However, a region under the bonding pad 45A contacts the first insulation layer 45, and suppresses said migration, thereby preventing a decline in the adhesivity of wire bonding.

Even where the first alloy wiring layer contains silicon or copper, this invention prevents the bonding adhesivity from being reduced, and consequently can manufacture a semiconductor device with high reliability and yield.

The foregoing embodiments refer to the case where a second wiring layer for the formation of a bonding pad was made of pure aluminium. However, the material of the second wiring layer need not be limited to pure aluminium. Instead, gold can obviously be applied as the material of the second wiring layer.

**Claims**

1. A semiconductor device having a bonding pad, comprising:

a semiconductor substrate (31) on which at least one semiconductor element is formed;

a first insulation layer (32) deposited at least partly on the main surface of the semiconductor substrate (31);

a first alloy wiring layer (33) contacting the semiconductor element disposed on the first insulation layer (32);

a second insulation layer (34) provided on the first alloy wiring layer (33) and; first insulation layer (32); and

a second wiring layer (35) contacted with the first alloy wiring layer (33), part of the second wiring layer constituting a bonding pad area (35); characterized in that

the bonding area (35A) is laterally shifted from an area where the second wiring layer (35) contacts the first alloy wiring layer (33) through an opening in the second insulation layer (34);

the first insulation layer (32) has a relatively high density as compared to the density of the second insulation layer (34); and

the bonding pad area (35A) is provided only on the first insulation layer (32).

2. The semiconductor device according to claim 1, characterized in that the first insulation layer (32) is a thermally oxidized layer produced during the manufacture of the device.

3. The semiconductor device according to claim 1, characterized in that the first insulation layer (32) is a layer of SiN or $SiO_2$ deposited by a chemical vapor deposition process and later heat treated at a relatively high temperature.

4. The semiconductor device according to claim 1, characterized in that the first alloy wiring layer (33) is formed of an aluminium alloy containing at least one metal selected from the group consisting of silicon, copper, palladium, titanium and molybdenum.

5. The semiconductor device according to claim 1, characterized in that the first alloy wiring layer (33) is formed of polysilicon containing a metal other than silicon.

6. The semiconductor device according to claim 1, characterized in that the second layer (34) is formed of an organic electrical insulation material.

7. The semiconductor device according to claim 1, characterized in that the second insulation layer (34) is formed of an inorganic electrical insulation material.

8. The semiconductor device according to claim 1, 2, 3, 4, 5 or 6, characterized in that the second wiring layer (35) is formed of pure aluminium heat-treated for an ohmic contact between said second wiring layer (35) and the first alloy wiring layer (33).

**Patentansprüche**

1. Halbleitervorrichtung mit Anschlußelektrode, umfassend ein Halbleitersubstrat (31), auf dem mindestens ein Halbleiterelement ausgebildet ist, eine zumindest teilweise auf der Hauptfläche des Halbleitersubstrats (31) abgelagerte erste Isolierschicht (32),

eine erste Legierungs-Verdrahtungsschicht (33), welche das auf der ersten Isolierschicht (32) angeordnete Halbleiterelement kontaktiert,

eine auf der ersten Legierungs-Verdrahtungsschicht (33) und der ersten Isolierschicht (32) vorgesehene zweite Isolierschicht (34) und

eine mit der ersten Legierungs-Verdrahtungsschicht (33) kontaktierte zweite Verdrahtungsschicht (35), deren einer Teil einen Anschlußelektrodenbereich (35) bildet, dadurch gekennzeichnet, daß

der Anschluß(elektroden)bereich (35A) seitlich gegenüber einem Bereich versetzt ist, in welchem die zweite Verdrahtungsschicht (35) die erste Legierungs-Verdrahtungsschicht (33) durch eine Öffnung in der zweiten Isolierschicht (34) kontaktiert,

die erste Isolierschicht (32) im Vergleich zur Dichte der zweiten Isolierschicht (34) eine verhältnismäßig große Dichte aufweist und

der Anschlußelektrodenbereich (35A) nur auf der ersten Isolierschicht (32) vorgesehen ist.

2. Halbleitervorrichtung nach Anspruch 1, dadurch gekennzeichnet, daß die erste Isolierschicht (32) eine bei der Herstellung der Vorrichtung erzeugte, thermisch oxidierte Schicht ist.

3. Halbleitervorrichtung nach Anspruch 1, dadurch gekennzeichnet, daß die erste Isolierschicht (32) eine Schicht aus SiN oder $SiO_2$ ist, die nach einem chemischen Aufdampfverfahren abgelagert und später bei vergleichsweise hoher Temperatur wärmebehandelt worden ist.

4. Halbleitervorrichtung nach Anspruch 1, dadurch gekennzeichnet, daß die erste Legierungs-Verdrahtungsschicht (33) aus einer mindestens ein Metall aus der Gruppe Silizium, Kupfer, Palladium, Titan und/oder Molybdän enthaltenden Aluminiumlegierung geformt ist.

5. Halbleitervorrichtung nach Anspruch 1, dadurch gekennzeichnet, daß die erste Legierungs-Verdrahtungsschicht (33) aus Polysilizium, enthaltend ein von Silizium verschiedenes Metall, geformt ist.

6. Halbleitervorrichtung nach Anspruch 1, dadurch gekennzeichnet, daß die zweite (Isolier-)Schicht (34) aus einem organischen elektrisch isolierenden Werkstoff geformt ist.

7. Halbleitervorrichtung nach Anspruch 1, dadurch gekennzeichnet, daß die zweite Isolierschicht (34) aus einem anorganischen elektrisch isolierenden Werkstoff geformt ist.

8. Halbleitervorrichtung nach Anspruch 1, 2, 3, 4, 5 oder 6, dadurch gekennzeichnet, daß die zweite Verdrahtungsschicht (35) aus reinem, für einen ohmschen Kontakt zwischen der zweiten Verdrahtungsschicht (35) und der ersten Legierungs-Verdrahtungsschicht (33) wärmebehandeltem Aluminium geformt ist.

**Revendications**

1. Dispositif semiconducteur muni d'un plot de connexion comprenant:

un substrat semiconducteur (31) sur lequel au moins un élément semiconducteur est formé;

une première couche isolante (32) déposée au moins partiellement sur la surface principale du substrat semiconducteur (31);

une première couche de câblage en alliage (33) en contact avec un élément semiconducteur disposée sur la première couche isolante (32);

une seconde couche isolante (34) prévue sur la première couche de câblage en alliage (33) et la première couche isolante (32); et

une seconde couche isolante (35) en contact avec la première couche de câblage en alliage (33); une partie de la seconde couche de câblage constituant une zone de plot de connexion (35); caractérisé en ce que:

la zone de connexion (35A) est décalée latéralement par rapport à la zone où la seconde couche (35) est en contact avec la première couche de câblage en alliage (33) par l'intermédiaire d'une ouverture dans la seconde couche isolante (34),

la première couche isolante (32) a une densité relativement élevée par rapport à la densité de la seconde couche isolante (34), et

la zone de plot de connexion (35A) est prévue seulement sur la première couche isolante (32).

2. Dispositif semiconducteur selon la revendication 1, caractérisé en ce que la première couche isolante (32) est une couche oxydée thermiquement produite pendant la fabrication du dispositif.

3. Dispositif semiconducteur selon la revendication 1, caractérisé en ce que la première couche isolante (32) est une couche de SiN ou SiO$_2$ déposée par un procédé de dépôt chimique en phase vapeur et traitée ensuite thermiquement à une température relativement élevée.

4. Dispositif semiconducteur selon la revendication 1, caractérisé en ce que la première couche de câblage en alliage (33) est formée d'un alliage d'aluminium contenant au moins un métal choisi dans le groupe comprenant le silicium, le cuivre, le palladium, le titane et le molybdène.

5. Dispositif semiconducteur selon la revendication 1, caractérisé en ce que la première couche de câblage en alliage (33) est formée de silicium polycristallin contenant un métal autre que du silicium.

6. Dispositif semiconducteur selon la revendication 1, caractérisé en ce que la seconde couche (34) est formée d'un matériau organique électriquement isolant.

7. Dispositif semiconducteur selon la revendication 1, caractérisé en ce que la seconde couche isolante (34) est formée d'un matériau minéral électriquement isolant.

8. Dispositif semiconducteur selon la revendication 1, 2, 3, 4, 5, ou 6, caractérisé en ce que la seconde couche de câblage (35) est formée d'aluminium pur traité thermiquement pour obtenir un contact ohmique entre la seconde couche de câblage (35) et la première couche de câblage en alliage (33).

# F I G. 1

# F I G. 5

36a

33

IVa'        IVa'

35A

35

# F I G. 2a

# F I G. 2b

# F I G. 3a

# F I G. 3b

# F I G . 4a

# F I G . 4b

# F I G. 6a

47   45A   44   46   45   44   43   42   41

# F I G. 6b

45A   47   46   45

VI   VI